# EUROPEAN PATENT APPLICATION

(11) **EP 4 746 299 A1**
(43) Date of publication of application: **20.05.2026**
(21) Application number: 24213240.5
(22) Date of filing: 15.11.2024
(51) Int. Cl.: H03L 7/093, H03L 7/085

(54) **DIGITAL PHASE-LOCKED LOOP WITH DIGITAL LOOP FILTER COMPRISING NOISE CANCELLATION PATH, AND METHOD OF OPERATING SAME**

(71) Applicant: Stichting IMEC Nederland, 5656 AE Eindhoven (NL)
(72) Inventor: XU, Zule, 5706 PP Helmond (NL); VAN DEN HEUVEL, Johan, 5663 RD Geldrop (NL)
(74) Representative: Sarlet, Stephanie

(57) **Abstract**

Digital phase-locked loop, DPLL, comprising: a time-to-digital converter, TDC, configured to generate a digital phase signal indicative of a phase difference between a reference signal and a feedback signal; a digitally controlled oscillator, DCO, configured to generate an output signal based on a control signal, wherein the output signal of the DCO is fed back as the feedback signal to the TDC; and a digital loop filter, DLF, configured to process the digital phase signal to generate the control signal for the DCO, wherein the DLF includes a noise cancellation path, or digital noise cancellation block, configured to generate a noise cancellation signal for suppressing DCO phase noise based on the digital phase signal.

## Description

### Field of the disclosure

The present disclosure relates to a digital phase-locked loop and a method of operating a digital phase-locked loop.

### Background art

A phase-locked loop, PLL, is a negative feedback circuit whose output frequency precisely tracks multiple times of the input reference frequency. PLLs are widely employed in wireless/wireline communications, Frequency Modulated Continuous Wave Radar, FMCW, radars, and high-speed sampling systems, where precise frequency synthesis is critical to system performance. If the control signals inside the loop are digital, the PLL is called a digital PLL. A digital PLL generally comprises a time-to-digital converter, a counter, a digital loop filter, and a digitally controlled oscillator, DCO.

The phase noise from the DCO degrades PLL spectral purity. A wider loop bandwidth could be set to suppress DCO's phase noise, but this would have as a consequence that the loop stability is degraded as well, and noise tends to be exaggerated around the cutoff frequency.

Recently, delay-lined-based noise cancellation has been proposed by adding a variable delay line at the DCO's output to cancel its phase noise. For example, Zhi-Heng Kang et al. "A 1.6-GHz DPLL Using Feedforward Phase-Error Cancellation", IEEE Journal of Solid-State Circuits, vol. 58, no. 3, pp. 1234-1245, Mar. 2023, disclose a digital phase-locked loop , DPLL, using a feedforward phase-error cancellation. The phase error of this DPLL using a digitally controlled ring oscillator is quickly cancelled by a digitally controlled delay line , DCDL, which improves the phase noise performance.

Such delay-lined-based noise cancellation may have disadvantages. It may suffer from delay line noise, higher power consumption, and higher complexity. It may also necessitate a precise gain calibration but still with some gain error that potentially degrades the performance.

### Summary of the disclosure

It is an aim of the present disclosure to provide an improved DPLL with noise cancellation in the digital domain.

In an aspect, which may be combined with other aspects and/or embodiments described herein, the present disclosure relates to a digital phase-locked loop, DPLL, comprising: a time-to-digital converter, TDC, configured to generate a digital phase signal indicative of a phase difference between a reference signal and a feedback signal; a digitally controlled oscillator, DCO, configured to generate an output signal based on a control signal, wherein the output signal of the DCO is fed back as the feedback signal to the TDC; and a digital loop filter, DLF, configured to process the digital phase signal to generate the control signal for the DCO, wherein the DLF includes a noise cancellation path, or digital noise cancellation block, configured to generate a noise cancellation signal for suppressing DCO phase noise based on the digital phase signal.

In this way, a DPLL with DCO phase noise cancellation in the digital domain may be achieved. This may result in one or more of the following advantages: lower hardware overhead, reduced complexity, lower cost, noise cancellation operating at lower frequency leading to lower power consumption, less additional noise (such as the noise from a variable delay line), no requirement of precise gain calibration leading to no gain errors.

In embodiments, the noise cancellation path comprises a differentiator configured for differentiating the digital phase signal.

In embodiments, the noise cancellation path comprises a filter configured to enhance open-loop gain within a predetermined frequency range corresponding to a loop bandwidth of the PLL. Preferably, the filter is an infinite impulse response, IIR, filter, preferably a first order low-pass filter. For effective noise cancellation, a high gain may be needed for the differentiator, which may in turn increase noise contribution from the TDC. To compensate this additional noise, the filter, preferably IIR filter, may be inserted after the differentiator to enhance the open-loop gain while mitigating the TDC noise contribution.

In embodiments, the noise cancellation path is configured for multiplying the digital phase signal by a derivative loop gain. This allows tuning the amount of noise cancellation.

In embodiments, the DLF comprises a proportional-integral controller, PIC, comprising a proportional path configured for multiplying the digital phase signal by a proportional loop gain and an integration path configured for integrating the digital phase signal and multiplying by an integral loop gain.

In embodiments, the proportional loop gain, the integral loop gain and the derivative loop gain are preferably linked such that the corner frequency of the IIR filter in the noise cancellation path is close to or less than that of the PIC.

In an aspect, which may be combined with other aspects and/or embodiments described herein, the present disclosure relates to a method for operating a digital phase-locked loop DPLL, comprising the steps of: generating a digital phase signal indicative of a phase difference between a reference signal and a feedback signal by means of a time-to-digital converter, TDC; generating an output signal by means of a digitally controlled oscillator, DCO, based on a control signal, wherein the output signal of the DCO is fed back as the feedback signal to the TDC; and processing the digital phase signal by means of a digital loop filter, DLF, to generate the control signal for the DCO, wherein the DLF includes a noise cancellation path that generates a noise cancellation signal for suppressing DCO phase noise based on the digital phase signal.

In embodiments, the noise cancellation path comprises a differentiator that differentiates the digital phase signal.

In embodiments, the noise cancellation path comprises a filter that enhances open-loop gain within a predetermined frequency range corresponding to a loop bandwidth of the PLL. In embodiments, the filter is an infinite impulse response, IIR, filter, preferably a first order low-pass filter.

In embodiments, the digital phase signal is multiplied in the noise cancellation path by a derivative loop gain.

In embodiments, the DLF comprises a proportional-integral controller, PIC, comprising a proportional path wherein the digital phase signal is multiplied by a proportional loop gain and an integration path that integrates the digital phase signal and wherein the digital phase signal is multiplied by an integral loop gain.

In embodiments, the proportional loop gain, the integral loop gain and the derivative loop gain are preferably linked such that the corner frequency of the IIR filter in the noise cancellation path is close to or less than that of the PIC.

### Brief description of the drawings

Embodiments of the present disclosure will be discussed in more detail below, with reference to the attached drawings.
Fig. 1 schematically shows the operation principle of a DPLL according to the present disclosure.
Fig. 2 shows an embodiment of a DPLL according to the present disclosure.
Fig. 3 shows another embodiment of a DPLL according to the present disclosure.
Fig. 4 shows the effect of the noise cancellation in the digital domain according to the present disclosure.

### Description of embodiments

The following terms are provided solely to aid in the understanding of the present disclosure.

As used herein, the term "digital phase-locked loop" or "DPLL" refers to a phase-locked loop system implemented using digital components and signals, configured to synchronize the phase and frequency of an output signal with those of a reference signal by processing signals digitally within the loop. Examples of specific embodiments include DPLLs comprising digital phase detectors like time-to-digital converters, digital loop filters, and digitally controlled oscillators.

As used herein, the term "time-to-digital converter" or "TDC" refers to a circuit component configured to measure the time difference between two signals and convert this time difference into a corresponding digital value representing the phase difference between the signals. Specific embodiments of a TDC may include delay line-based TDCs, Vernier TDCs, or counter-based TDCs.

As used herein, the term "digital phase signal" refers to a digital representation of the phase difference between a reference signal and a feedback signal, as generated by the TDC in the DPLL system. This signal serves as an input to the digital loop filter for further processing.

As used herein, the term "digitally controlled oscillator" or "DCO" refers to an oscillator whose output frequency can be controlled by a digital control signal, producing an output signal whose frequency and phase are adjustable in discrete steps based on digital inputs. Examples of DCO embodiments include ring oscillators or LC oscillators with digitally controlled capacitors or varactors.

As used herein, the term "digital loop filter" or "DLF" refers to a digital signal processing component configured to process the digital phase signal to generate the control signal for the DCO, thereby forming a part of the feedback control loop in the DPLL. According to the present disclosure, the DLF may include components such as proportional-integral controllers and comprises a noise cancellation path.

As used herein, the term "noise cancellation path" refers to a signal processing path within the DLF that is configured to generate a noise cancellation signal based on the digital phase signal, wherein this noise cancellation signal is used to suppress phase noise originating from the DCO. Specific embodiments may involve differentiators and filters that enhance open-loop gain within certain frequency ranges.

As used herein, the term "noise cancellation signal" refers to a signal generated within the noise cancellation path of the DLF, which is utilized to counteract and suppress the phase noise introduced by the DCO in the DPLL system. This signal aids in improving the phase noise performance of the overall system.

As used herein, the term "differentiator" refers to a digital signal processing component configured to compute the discrete-time derivative of the digital phase signal, effectively measuring the rate of change of the phase difference between the reference and feedback signals. An example embodiment is a digital differentiator implemented using finite difference methods.

As used herein, the term "infinite impulse response filter" or "IIR filter" refers to a digital filter whose impulse response extends indefinitely due to internal feedback, characterized by a recursive computation that depends on both current and past input values as well as past output values. A specific embodiment includes a first-order low-pass IIR filter.

As used herein, the term "proportional-integral controller" or "PIC" refers to a digital controller within the DLF that comprises both proportional and integral control paths. The proportional path scales the digital phase signal by a proportional loop gain, responding directly to the current phase error, while the integration path accumulates the phase error over time, scaling it by an integral loop gain to eliminate steady-state errors. Specific embodiments may include implementation using digital accumulators and multipliers.

A phase-locked loop, PLL, is a negative feedback circuit whose output frequency precisely tracks multiple times of the input reference frequency. PLLs are widely employed in wireless and wireline communications, Frequency Modulated Continuous Wave Radar, FMCW, radars, and high-speed sampling systems, where precise frequency synthesis is critical to system performance. If the control signals inside the loop are digital, the PLL is called a digital PLL. A digital PLL generally comprises a time-to-digital converter, a counter, a digital loop filter, and a digitally controlled oscillator, DCO.

In general, the PPLs according to the present disclosure are suitable for low power communication systems (both wired and wireless) requiring precise frequency synthesis. Apart from the FMCW radar or the high-speed sampling systems, the PPLs according to the present disclosure are particularly suitable for UWB and Bluetooth communication systems where ring oscillators are used.

Further, the PPLs according to the present disclosure are suitable for systems where a low jitter clock is desired, such as a system on chip, SoC, a CPU, a GPU, or other.

In principle, a DCO integrates frequency information into phase. The phase noise from the DCO may thus degrade the PLL spectral purity. A conventional technique to address this issue is noise cancellation carried out in the (analog) phase domain. This may introduce the above-mentioned disadvantages such as delay line noise, higher power consumption, higher complexity, need for a precise gain calibration but still with some gain error that potentially degrades the performance.

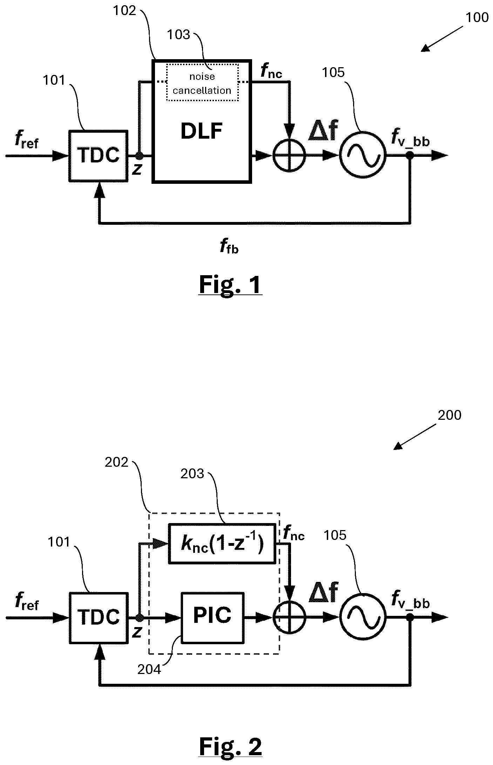

According to the disclosure, it is proposed to cancel noise at the input of DCO, in the digital loop filter, DLF. The principle is shown in Figure 1 which shows a digital phase-locked loop, DPLL, 100 comprising a time-to-digital converter, TDC, 101 that generates a digital phase signal z indicative of a phase difference between a reference signal *f*_{ref} and a feedback signal *f*_{fb}, a digitally controlled oscillator, DCO, 105 that generates an output signal *f*_{v_bb} based on a control signal *Δf.* The output signal of the DCO 105 is fed back as the feedback signal *f*_{fb} to the TDC 101. A digital loop filter, DLF, 102 processes the digital phase signal z to generate the control signal Δ*f* for the DCO 105 and includes a noise cancellation path or noise cancellation block 103 that generates a noise cancellation signal *f*_{nc} intended to suppress DCO phase noise, based on the digital phase signal *z*.

The DPLL 100 is thus provided with DCO phase noise cancellation in the digital domain. This may result in one or more of the following advantages: lower hardware overhead, reduced complexity, lower cost, noise cancellation operating at lower frequency leading to lower power consumption, less additional noise (such as the noise from a variable delay line), no requirement of precise gain calibration leading to no gain errors.

Fig. 2 shows a first embodiment in which the principle of Fig. 1 is implemented. In particular, in the DPLL 200 of Fig. 2, the DLF 202 comprises a proportional-integral controller ,PIC , 204, which is a known implementation of a digital loop filter, and in addition, in parallel over the PIC 204, a noise cancellation path comprising a differentiator 203 that differentiates the digital phase signal z and applies a differentiator gain *k*_{nc}. The noise cancellation path with differentiator obtains frequency information from the digital phase signal z and processes it to provide the noise cancellation signal *f*_{nc} at the input of the DCO 105. The control signal Δ*f* for the DCO 105 is thus the addition of the output of the PIC 204 and the noise cancellation signal *f*_{nc}. In the embodiment of Fig. 2, high gain *k*_{nc} may be needed for the differentiator 203 for effective noise cancellation. This high gain may increase the noise contribution from the TDC 101, which may be addressed by the addition of a filter in the noise cancellation path.

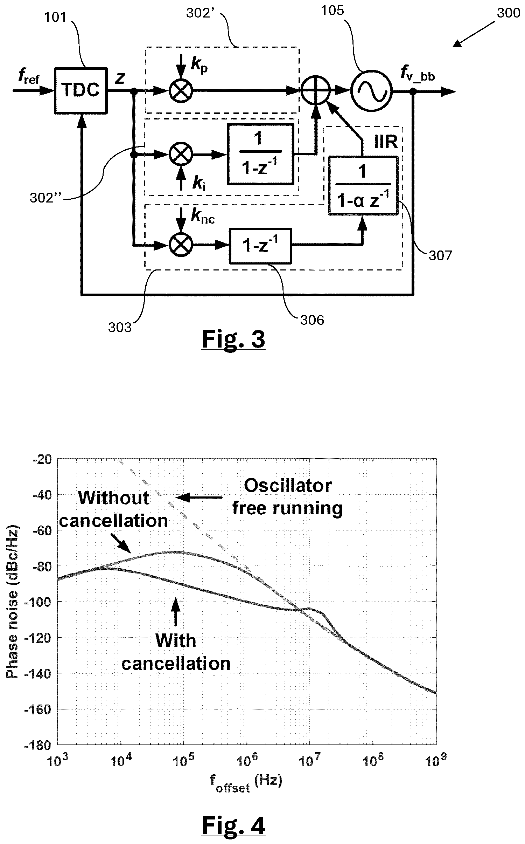

Fig. 3 shows another embodiment in which the principle of Fig. 1 is implemented. In particular, in the DPLL 300 of Fig. 3, the DLF comprises a proportional-integral controller, PIC 302'-302", and a noise cancellation path 303 as follows. The PIC comprises a proportional path 302' wherein the digital phase signal z is multiplied by a proportional loop gain *k*ₚ, and an integration path 302" wherein the digital phase signal *z* is integrated and multiplied by an integral loop gain *k*ᵢ. The noise cancellation path 303 comprises a differentiator 306 that differentiates the digital phase signal z and applies a differentiator gain *k*_{nc}. In order to reduce the noise contribution from the TDC 101 as a result of the gain needed for the noise cancellation, the noise cancellation path further comprises an IIR filter 307 (1 / (1 - α z⁻¹)) that enhances open-loop gain within a predetermined frequency range corresponding to the loop bandwidth of the DPLL 300. The coefficient α is preferably within (0, 1) so that the IIR filter is a 1^{st}- order low-pass filter. The gain factors, in particular the proportional loop gain *k*ₚ, the integral loop gain *k*ᵢ, and the differentiator gain *k*_{nc} are preferably linked in such a way that the corner frequency of the IIR filter in the noise cancellation path is close to or less than that of the PIC. In this way, as the PIC and the IIR filter are both connected to the (same) phase detector, i.e. the TDC 101, and are both connected at the output, they experience the same analog gain error. Then, if there is an analog gain error, both the loop filter and the noise cancellation path suffer in a similar manner and the noise is still suppressed in the right region in relation to the loop filter of the ADPLL.

### Experimental results

Fig. 4 shows a graph obtained by numerical noise analysis in Matlab using the structure of Fig. 3, where the gains of TDC and DCO are normalized. With known reference frequency (*f*_{ref} = 100MHz), output frequency (*f*_{v_bb} = 12.7GHz), input referenced phase noise (at least a rough estimation is needed, we assume only white noise of about 0.3 psec/rms), and DCO free-running phase noise (shown in Fig.4), then the parameters for the phase cancellation loop were set as follows:
- proportional loop gain *k*ₚ: 0.0627
- integral loop gain *k*ᵢ: 0.00024567
- differentiator gain *k*_{nc}: 0.5
- IIR filter coefficient α: 0.9999

The graph of Fig. 4 compares the phase noise of the free running DCO, the DCO without noise cancellation (DLF "on" but noise cancellation "off') and the DCO with noise cancellation (DLF and noise cancellation "on"). The graph clearly shows the improvement within the loop bandwidth of the DPLL, which is in this example from about 50kHz up to an offset frequency of 10 MHz.

## Claims

1. A digital phase-locked loop, DPLL, comprising:
a time-to-digital converter, TDC, configured to generate a digital phase signal indicative of a phase difference between a reference signal and a feedback signal,
a digitally controlled oscillator, DCO, configured to generate an output signal based on a control signal, wherein the output signal of the DCO is fed back as the feedback signal to the TDC,
a digital loop filter, DLF, configured to process the digital phase signal to generate the control signal for the DCO, wherein the DLF includes a noise cancellation path configured to generate a noise cancellation signal for suppressing DCO phase noise based on the digital phase signal.

2. The DPLL of claim 1, wherein the noise cancellation path comprises a differentiator configured for differentiating the digital phase signal.

3. The DPLL of claim 1 or 2, wherein the noise cancellation path comprises a filter configured to enhance open-loop gain within a predetermined frequency range corresponding to a loop bandwidth of the PLL.

4. The DPLL of claim 3, wherein the filter is an infinite impulse response, IIR, filter, preferably a first order low-pass filter.

5. The DPLL of any preceding claim, wherein the noise cancellation path is configured for multiplying the digital phase signal by a derivative loop gain.

6. The DPLL of any preceding claim, wherein the DLF comprises a proportional-integral controller, PIC, comprising a proportional path configured for multiplying the digital phase signal by a proportional loop gain and an integration path configured for integrating the digital phase signal and multiplying by an integral loop gain.

7. The DPLL of claims 5 and 6, wherein the proportional loop gain, the integral loop gain and the derivative loop gain are linked such that the corner frequency of the IIR filter in the noise cancellation path is close to or less than that of the PIC.

8. An electronic device comprising at least one DPLL according to any one of the preceding claims, preferably wherein the DCO is a ring oscillator.

9. A method for operating a digital phase-locked loop DPLL, comprising the steps of:
generating a digital phase signal indicative of a phase difference between a reference signal and a feedback signal by means of a time-to-digital converter, TDC,
generating an output signal by means of a digitally controlled oscillator, DCO, based on a control signal, wherein the output signal of the DCO is fed back as the feedback signal to the TDC,
processing the digital phase signal by means of a digital loop filter, DLF, to generate the control signal for the DCO, wherein the DLF includes a noise cancellation path that generates a noise cancellation signal for suppressing DCO phase noise based on the digital phase signal.

10. The method of claim 9, wherein the noise cancellation path comprises a differentiator that differentiates the digital phase signal.

11. The method of claim 9 or 10, wherein the noise cancellation path comprises a filter that enhances open-loop gain within a predetermined frequency range corresponding to a loop bandwidth of the PLL.

12. The method of claim 11, wherein the filter is an infinite impulse response, IIR, filter, preferably a first order low-pass filter.

13. The method of any of claims 9-12, wherein in the noise cancellation path the digital phase signal is multiplied by a derivative loop gain.

14. The method of any of claims 9-13, wherein the DLF comprises a proportional-integral controller, PIC, comprising a proportional path wherein the digital phase signal is multiplied by a proportional loop gain and an integration path that integrates the digital phase signal and wherein the digital phase signal is multiplied by an integral loop gain.

15. The method of any of claims 13 and 14, wherein the proportional loop gain, the integral loop gain and the derivative loop gain are linked such that the corner frequency of the IIR filter in the noise cancellation path is close to or less than that of the PIC.
